# EUROPEAN PATENT APPLICATION

(11) **EP 4 462 618 A1**
(43) Date of publication of application: **13.11.2024**
(21) Application number: 23184573.6
(22) Date of filing: 11.07.2023
(51) Int. Cl.: H01S 5/042, H01S 5/04, H01S 5/10, H01S 5/20, H01S 5/343, H01S 5/02, H01S 5/22

(54) **HETEROGENEOUSLY INTEGRATED PHOTONIC PLATFORM WITH INGAP LAYERS**

(30) Priority: 07.05.2023 US 202318313347
(71) Applicant: Nexus Photonics, Inc., Goleta, CA 93117 (US)
(72) Inventor: ZHANG, Chong, Santa Barbara, 93111 (US); ZHANG, Zeyu, Goleta, 93117 (US); TRAN, Minh, Goleta, 93117 (US); KOMLJENOVIC, Tin, Goleta, 93117 (US)
(74) Representative: Isarpatent

(57) **Abstract**

A heterogenous device includes a passive waveguide structure and an active waveguide structure. The passive waveguide structure is attached to a substrate and includes a dielectric layer. The active waveguide structure is attached to a top surface of the passive waveguide structure and includes a quantum well layer overlying an InGaP layer. The InGaP layer provides n-contact functionality.

A heterogenous device includes a passive waveguide structure and an active waveguide structure. The passive waveguide structure is attached to a substrate and includes a semiconductor layer. The active waveguide structure is attached to a top surface of the passive waveguide structure and includes a quantum well layer overlying an InGaP layer. The InGaP layer provides n-contact functionality.

## Description

### Field of the Invention

The present invention relates to photonic integrated circuits. More specifically, certain embodiments of the invention relate to improved performance of heterogeneously integrated lasers and active components with waveguides operating at short wavelengths using dissimilar materials that are optically coupled.

### Backaround of the Invention

A photonic integrated circuit (PIC) or integrated optical circuit is a device that integrates multiple photonic functions and as such is analogous to an electronic integrated circuit. The major difference between the two is that a photonic integrated circuit provides functions for information signals imposed on optical carrier waves. The material platform most commercially utilized for photonic integrated circuits is indium phosphide (InP), which allows for the integration of various optically active and passive functions on the same chip. Although many current PICs are realized in InP platforms, there has been significant research in the past decade in using silicon rather than InP for the realization of PICs, due to some superior characteristics as well as superior processing capabilities for the former material, that leverage the investment already made for electronic integrated circuits.

The biggest drawback in using silicon for PICs is that it is an indirect bandgap material which makes it hard to provide electrically pumped sources. This problem is generally solved by assembling PICs comprising two or more chips made from dissimilar materials in separate processes. Such an approach is challenging due to a need for very fine alignment, which increases packaging costs and introduces scaling limitations. Another approach to solving the bandgap problem is to bond two dissimilar materials and process them together, removing the need for precise alignment during the bonding of larger pieces or complete wafers of the dissimilar materials, and allowing for mass fabrication. In this disclosure, we use the term "hybrid" to describe the first approach that includes precise assembly of separately processed parts, and we use the term "heterogeneous" to describe the latter approach of bonding two materials and then processing the bonded result to define the waveguides and other components of interest.

To transfer the optical signal between dissimilar materials, the heterogeneous approach utilizes tapers whose dimensions are gradually reduced until the effective mode refractive indexes of dissimilar materials match and there is efficient power transfer. This approach generally works well when materials have small difference in refractive indexes as is the case with silicon and InP. In cases where there is larger difference in effective indexes, such as between e.g. SiN and GaAs (and its ternaries and quaternaries), the requirements on taper tip dimensions become prohibitive limiting efficient power transfer. Specifically, extremely small taper tip widths (of the order of tens of nanometers) may be necessary to provide good coupling. Achieving such dimensions is complex and may be cost prohibitive.

Although InP and silicon-based PICs address many current needs, they have some limitations; among them the fact that the operating wavelength range is limited by material absorption increasing the losses, and the fact that there is a limit on the maximum optical intensities and consequently optical powers that a PIC can handle. To address these limitations, alternate waveguide materials have been considered, such as SiN, SiNOx, LiNbO₃, TiO₂, Ta₂O₅, AlN or others. In general, such dielectric waveguides have higher bandgap energies which provides better high-power handling and transparency at shorter wavelength, but, in general such materials also have lower refractive indexes. E.g., SiN with bandgap of ∼5 eV has refractive index of ∼2, AIN has bandgap of ∼6 eV and refractive index of around ∼2, and SiO₂ with bandgap of ∼8.9 eV has refractive index of ∼1.44. For comparison, the refractive index of GaAs is >3. This makes the tapered approach challenging.

The alternative hybrid approach suffers from the drawbacks already mentioned above, namely the need for precise alignment, and correspondingly complex packaging and scaling limitations.

A recent approach to the problems discussed above was presented in U. S. Patent No. 10,859,764 B2 employing butt-coupling in combination with a mode-converter to allow the heterogenous process to be used without the need for extremely small taper widths. Although providing good performance when operating at longer wavelengths, this becomes more challenging when operating at shorter wavelengths due to limitations primarily related to contact layers. In many native lasers (e.g., commercial InP or GaAs lasers made on the same type of substrate) current typically spreads from top to bottom, so a thick cladding can be used to control losses from the contact layers, even if those layers are absorptive at the wavelength of operation. In typical heterogeneous integration, the mode has a significant overlap with at least one of the contact layers, as current usually spreads from the top to sides. For heterogeneous silicon integration see e.g. Komljenovic et al, "Photonic integrated circuits using heterogeneous integration on silicon" (DOI: https://doi.org/10.1109/JPROC.2018.2864668), for heterogeneous silicon-nitride integration see e.g., Tran et al, "Extending the spectrum of fully integrated photonics to submicrometre wavelengths" (DOI: https://doi.org/10.1038/s41586-022-05119-9). The former approach to heterogenous integration is typically used to cover wavelength range from 1250 nm to 1700 nm, while the latter approach including butt coupling and mode conversion has been used to cover the wavelength range from ∼975 nm to 1050 nm, and can operate down to ∼900 nm.

One proposed solution is to increase cladding thicknesses such that the bottom contact is far away from the optical mode, as is discussed in U.S. Patent Application 18,071,239, but this approach might require a more complex coupling structure (typically with more than one layer) and more complex overall process while still incurring relatively high coupling loss between the gain/active structure and the passive structure. One of the primary reasons for higher loss is the large vertical offset of the centers of the optical mode in active and passive structure. This large offset also limits the ability to use the passive structure to define a periodic structure that is evanescently coupled to the active structure, a common way of making distributed feedback (DFB) lasers.

Many applications need optical sources and PICs operating below 900 nm wavelength, for which a GaAs-based gain material system provides good performance all the way down to 630 nm wavelength. GaAs lasers typically utilize GaAs contacts whose bandgap is ∼870 nm resulting in very high loss if optical mode of a laser operating below or around the bandgap wavelength has any overlap with the contact layer. To provide transparency at shorter wavelengths, AlₓGa₁₋ₓAs is sometimes used as cladding, and could be used as contacts but a high Al concentration has significant challenges in many aspects of heterogeneous lasers. It is challenging to process, can result in higher loss, has reliability concerns, is very challenging to make good contacts with it (there is a thermal budget limitation in heterogeneous lasers due to a difference in coefficients of thermal expansion between the substrate and the bonded material), and is challenging to bond with high yield. For all these reasons, it is evident that there is an unmet need for high-performance heterogeneous lasers capable of operating below GaAs bandgap wavelengths.

The present invention is directed towards heterogeneous lasers and PICs operating around and below GaAs bandgap wavelengths, employing butt-coupling and taper structures to facilitate efficient coupling between active and passive waveguides to provide better performing active devices. In particular, embodiments described below are concerned with the detailed design of the laser structure to support high-yield bonding, high-performance contacts and robust semiconductor processing with high uniformity and yield.

### Brief Description of the Drawings

FIG. 1 illustrates a device according to one embodiment of the present invention, shown in cross-sectional end-on view.
FIG. 2 illustrates the impact of contact layer thickness on several confinement factors in exemplary heterogeneous lasers, and provides three illustrative mode shapes.
FIG. 3 shows six cross-sectional end-on views of devices according to some embodiments of the present invention illustrating processing steps to make the same.
FIG. 4 shows a cross-sectional view of a device according to some embodiments of the present invention.

### Detailed Description

Described herein are embodiments of a platform for realization of photonic integrated circuits using wafer bonding and deposition of dissimilar materials where optical coupling is improved by use of mode conversion and a butt-coupling scheme. More specifically, certain embodiments of the invention relate to detailed design of the laser structure to support high-yield bonding, high-performance contacts and robust processing with high uniformity and yield when operating at short wavelengths.

In the following detailed description, reference is made to the accompanying drawings which form a part hereof, wherein like numerals designate like parts throughout, and in which are shown by way of illustration embodiments in which the subject matter of the present disclosure may be practiced. It is to be understood that other embodiments may be utilized, and structural or logical changes may be made without departing from the scope of the present disclosure. Therefore, the following detailed description is not to be taken in a limiting sense, and the scope of embodiments is defined by the appended claims and their equivalents.

The description may use perspective-based descriptions such as top/bottom, in/out, over/under, and the like. Such descriptions are merely used to facilitate the discussion and are not intended to restrict the application of embodiments described herein to any particular orientation. The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The term "coupled with," along with its derivatives, may be used herein. "Coupled" may mean one or more of the following. "Coupled" may mean that two or more elements are in direct physical, electrical, or optical contact. However, "coupled" may also mean that two or more elements indirectly contact each other, but yet still cooperate or interact with each other, and may mean that one or more other elements are coupled or connected between the elements that are said to be coupled with each other. The term "directly coupled" means that two or more elements are in direct contact in at least part of their surfaces. The term "butt-coupled" is used herein in its normal sense of meaning an "end-on" or axial coupling, where there is minimal or zero axial offset between the elements in question. The axial offset may be, for example, slightly greater than zero in cases where a thin intervening layer of some sort is formed between the elements, such as e.g. thin coating layer typically used to provide high-reflectivity or anti-reflectivity functionality. It should be noted that the axes of two waveguide structures or elements need not be colinear for them to be accurately described as being butt-coupled. In other words, the interface between the elements need not be perpendicular to either axis in the case of e.g. angled interface. No adiabatic transformation occurs between butt-coupled structures.

Term "active device", "active structure" or otherwise "active" element, part, component may be used herein. A device or a part of a device called active is capable of light generation, amplification, modulation and/or detection using electrical contacts. This is in contrast to what we mean by a "passive device", "passive structure" or otherwise "passive" element whose principal function is to confine and guide light, and/or provide splitting, combining, filtering and/or other functionalities that are commonly associated with passive devices. Some passive devices can provide functions overlapping with active device functionality, such as e.g. phase tuning implemented using thermal effects or similar that can provide modulation. No absolute distinction should be assumed between "active" and "passive" based purely on material composition or device structure. A silicon device, for example, may be considered active under certain conditions of modulation, or detection of low wavelength radiation, but passive in most other situations.

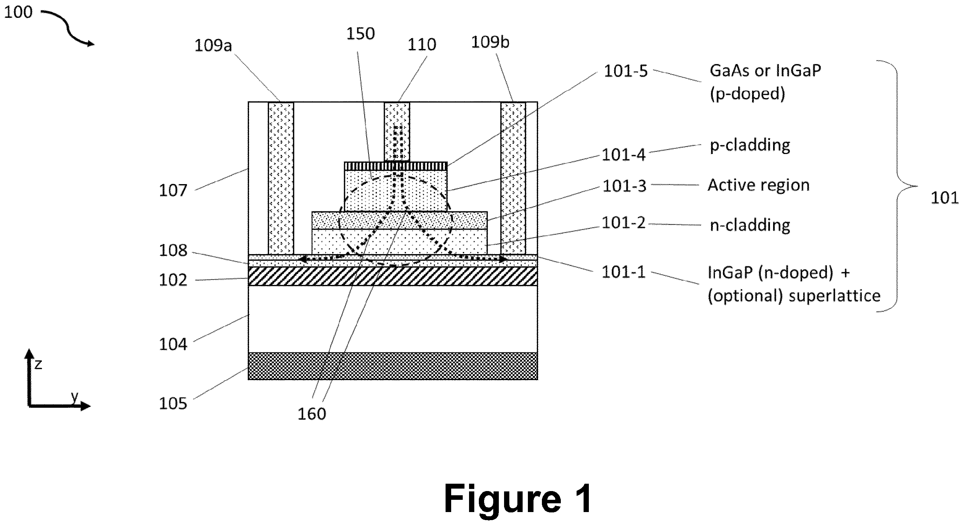

FIG. 1 is a schematic cross-section end-on view of heterogeneously integrated photonic device 100 optimized for operation at short wavelengths. In some embodiments, the wavelength of operation is shorter than 900 nm. The exemplary cross-section includes a substrate 105 that can be any suitable substrate for semiconductor and dielectric processing, such as Si, InP, GaAs, quartz, sapphire, glass, GaN, silicon-on-insulator or other materials known in the art. In the shown embodiment, a layer of second material 104 is deposited, grown, transferred, bonded or otherwise attached to the top surface of substrate 105 using techniques known in the field. The main purpose of layer 104 is to provide optical cladding for material 102 (to be described below), if necessary to form an optical waveguide. Optical waveguides are commonly realized by placing higher refractive index core between two lower refractive index layers to confine the optical wave. In some embodiments, layer 104 is omitted and substrate 105 itself serves as a cladding.

Layer 102 is deposited, grown, transferred, bonded or otherwise attached to the top of layer 104 if present, and/or to the top of substrate 105, using techniques known in the field. The refractive index of layer 102 is higher than the refractive index of layer 104 if present, or, if layer 104 is not present, the refractive index of layer 102 is higher than the refractive index of substrate 105. In one embodiment, the material of layer 102 may include, but is not limited to, one or more of SiN, SiNOₓ, TiO₂, Ta₂O₅, (doped) SiO₂, LiNbO₃ and AlN. In some embodiments, other common dielectric materials may be used for layer 102. In other embodiments, a high-bandgap semiconductor material may be used for layer 102. A high-bandgap semiconductor might be defined with bandgap energy larger than 1.5 eV (or bandgap wavelength shorter than 830 nm). Examples of high-bandgap semiconductor materials are GaN, AlGaN, AlGaAs (with Al concentration >5%) or similar, usually characterized by bandgap wavelength that is shorter than 700 nm. Either or both layers 104 and 102 can be patterned, etched, or redeposited to tailor their functionality (define waveguides, splitters, couplers, gratings and other passive components) as is common in the art (not shown in FIG. 1). Layer 102 corresponds to what is called a passive layer or structure in the remaining part of the disclosure, including the claims.

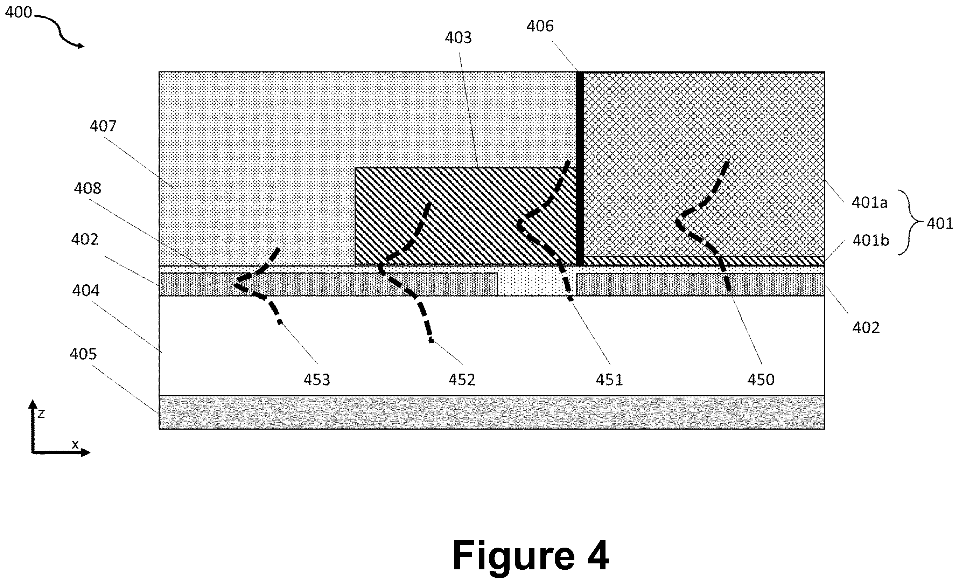

Layer 108, whose refractive index is lower than the refractive index of layer 102, overlays layer 102 and underlays layers 101 and 403 (not visible in FIG. 1, but described below with reference to FIG. 4). Layer 108 serves to planarize the patterned surface of layer 102 as further illustrated in FIG. 4. In some embodiments, the planarity of the top surface of layer 108 is provided by chemical mechanical polishing (CMP) or other etching, chemical and/or mechanical polishing methods. In other embodiments, the planarity is provided because of the intrinsic nature of the method by which layer 108 is deposited, for example if the material of layer 108 is a spin-on glass, polymer, photoresist or other suitable material. The planarization may be controlled to leave a layer of desired, typically very low, thickness on top of the layer 102 (as shown in FIG. 1), or to remove all material above the level of the top surface of the layer 102 (not shown). In cases where layer 108 is left on top of layer 102, the target thicknesses are in the range of 10 nm to several hundreds of nm, with actual thickness, due to planarization process non-uniformities, being between zero and several hundreds of nanometers larger than the target thickness. In some embodiments, spin-on material is used to planarize and is then etched back resulting with improved across wafer uniformity compared to typical CMP processes. Top surface of layer 108 is typically characterized with low surface roughness which makes it suitable for bonding. In some cases, roughness is <5 nm RMS, in yet other embodiments it is <1 nm RMS. It is generally known that bonding yield is improved as surface roughness is reduced. Good CMP process can result with surface roughness <0.5 nm RMS or lower (better).

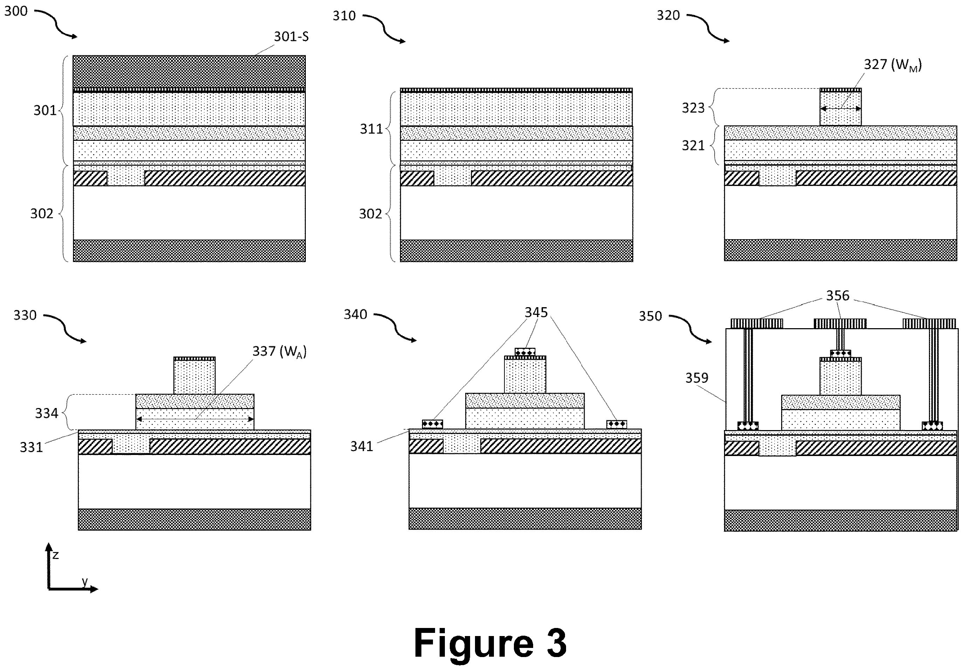

Layer 101 is bonded on top of at least part of the corresponding passive waveguide or passive waveguide structure (108, 102) top surface. The bonding can be direct molecular bonding, or additional materials can be used to facilitate bonding such as e.g., polymer films as is known in the art. The bonding material, if used, has to have reasonably low losses at the wavelength of operation as the optical mode 150 has some overlap with layer 108. Layer 101 makes up what is commonly called an active device, and is made up of materials including, but not limited to, GaAs and InP based ternary and quaternary materials. Layer 101 in some embodiments, and also as shown in FIG. 1 is multilayered, comprising sublayers providing both optical and electrical confinement as well as electrical contacts, as is known in the art for active devices. In the embodiment shown in FIG. 1, layer 101 comprises five distinct sublayers 101-1, 101-2, 101-3, 101-4 and 101-5, all of which can comprise additional sublayers. Sublayers of layer 101 in some embodiments provide vertical confinement (up/down in FIG. 1), while lateral confinement (left/right in FIG. 1) is provided by at least one etch as is known in the art for active devices and will be described in more details with the help of FIG. 3.

Layer 101 corresponds to what is called active layer, active waveguide, or active waveguide structure in the remaining part of the disclosure, including the claims.

Sublayer 101-1 comprises a highly doped InGaP n-doped contact layer. In some embodiments, the thickness of the InGaP n-doped contact layer is between 50 nm and 500 nm. The doping is typically greater or equal to 1e18 to provide good contacts, but in some embodiments can be lower. The doping can be constant, or piece-wise constant, or graded or a combination of any or all of these. In some embodiments, typically when the InGaP n-doped contact layer thickness is >150 nm, doping can be higher at the top (towards the contact), and lower at the bottom (toward the bonded interface with 108 or 102). This can result in reduced internal loss. Contacts 109a and 109b are laterally offset from the optical mode 150, so they do not contribute to the optical loss. Sublayer 101-1, in some embodiments, also comprises a superlattice realized by at least two thin layers with different properties. The superlattice can serve to prevent the propagation of dislocations, or otherwise facilitate more robust laser performance. In some embodiments, the superlattice is realized by thin layers of InGaP and AlInP. In some embodiments, a low strain is introduced into the superlattice layer to improve the dislocation filtering effect. The typical thickness of each superlattice layer is <10 nm but can be as thick as 50 nm. In most embodiments, superlattices prioritize InGaP as the final layer (at the bottom) due to its superior stability and processability. In some embodiments, the InGaP layer of sublayer 101-1 can be bonded directly to layer 102/108, without requiring additional thin layers.

The bandgap wavelength of InGaP with 51% of Ga is around 650 nm, enabling low optical loss for lasers operating from ∼660 nm and longer. The bandgap wavelength can be further reduced if Ga composition is increased, and with 70% Ga concentration it can be as low as 580 nm.

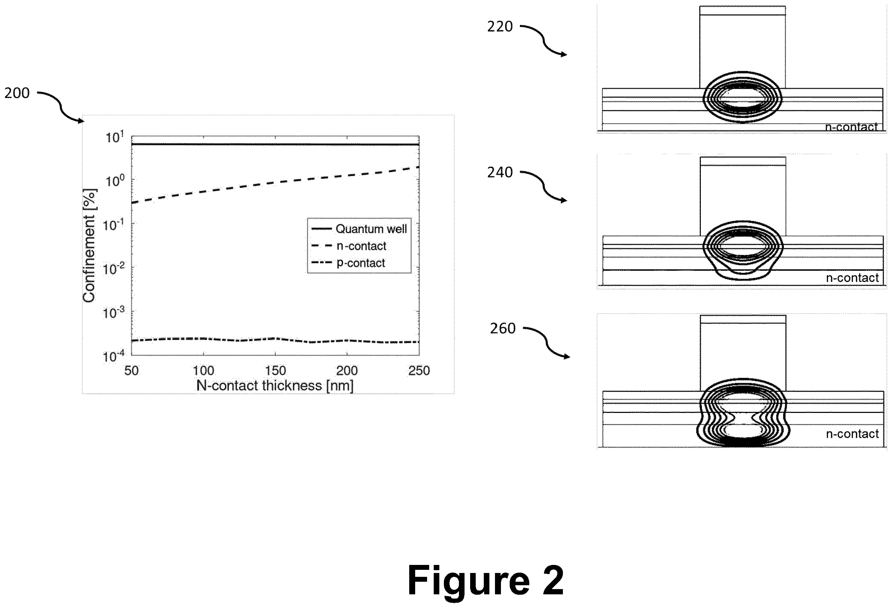

The thickness of InGaP contact layer 101-1 (comprising the highly-doped region) is an optimization parameter as it impacts the series resistance of the active device, impacts the confinement in the quantum well (as will be described in more detail with the help of FIG. 2), and impacts the process control requirements when contact is open with etching (as will be described in more detail with the help of FIG. 3).

Sublayers 101-2 and 101-3 define what is called the active width (see also view 330 showing width 337 in FIG. 3). In some embodiments, the active width can be the same as the mesa width (width 327 defined by patterned sublayers 101-4 and 101-5 as seen in view 320 in FIG. 3), but in the embodiment shown, active width 337 is larger than mesa width 327, with a goal of reducing the optical mode 150 overlap with the etched sidewall of the active region 101-3. Active region 101-3 comprises quantum well, quantum dot, p-n junction and/or p-i-n junction layers with optional separate-confinement heterostructure (SCH) layer(s). In the remainder of this disclosure, including the claims, the term "quantum well" is used for simplicity to include quantum dot layers, p-n junction layers, p-i-n junction layers as well as quantum well layers and/or combinations of two or more of them. In some embodiments, the top layer of sublayer 101-3 is InGaP, and it can serve as an etch stop layer to improve the uniformity of the etch and active devices as will be described with the help of FIG. 3.

Optional sublayer 101-2 can comprise what is commonly known as n-cladding and/or n-waveguide layers. In both cases, the layers of sublayers 101-2 would comprise optically transparent materials at the wavelength of operation with background doping that is typically smaller than in the contact region. In some embodiments doping can be 1e18 or lower. In other embodiments, doping can be constant, piece-wise constant, graded and/or a combination of some or all. Such layers, in some embodiments, can be realized with InGaP ternary and/or AlInGaP quaternary semiconductors, both of which can be grown on GaAs substrates with high quality. In other embodiments, the functionality of the n-cladding and/or n-waveguide can also be provided by the barrier layer and/or SCH layer in sublayer 101-3.

Sublayer 101-4 is the p-cladding layer, the cladding layer serving to reduce internal loss by controlling the overlap between the optical mode 150 and metal 110 and between the optical mode 150 and sublayer 101-5 providing p-contact functionality described below. Sublayer 101-4 can comprise additional layers such as bandgap smoothing layers, etch stop layers, graded layers, etc. to provide improved performance or facilitate more robust fabrication as is known in the art of semiconductor device design and fabrication. Sublayer 101-4 is doped, with doping levels typically between 1e16 and 2e18. The thickness of sublayer 101-4 varies depending on the wavelength of operation, and the refractive index difference between the p-cladding and sublayer 101-3 layers. In some embodiments, the thickness of the p-cladding layer is larger than 400 nm. The doping and thickness optimization achieves a balance between keeping series resistance through the p-cladding low while also keeping the optical loss acceptably low, noting that p-doped materials typically have higher optical loss than the n-doped materials, and that a thinner layer of p-cladding allows more mode overlap with the p-contact layer 101-5, described below. The doping of sublayer 101-4 can be constant, piece-wise constant, graded and/or combination of all. Both the contact resistance optimization and the optical loss optimization can be carried out with commercial numerical solvers or other simulation/calculation means including analytical expressions and approximation formulas. In some embodiments the p-cladding is realized with InGaP ternary and/or AlInGaP quaternary semiconductors

Sublayer 101-5 is the p-contact layer. In some embodiments sublayer 101-5 comprises a highly p-doped GaAs layer. In some embodiments the doping is >5e18. In yet other embodiments the doping is even higher, reaching 1e19 or more. The GaAs layer (with bandgap wavelength being longer than the laser operation wavelength) can be utilized for this contact as the relatively thick p-cladding keeps the overlap of the mode 150 and sublayer 101-5 very small. In other embodiments, a highly p-doped (>5e18) InGaP can also be utilized for the p-contact layer. In some embodiments the thickness of the contact layer is between 50 nm and 250 nm.

Contacts 109a, 109b and 110 provide ohmic contacts to respective semiconductor contact layers (as a part of sublayers 101-1 and 101-5). In some embodiments, contact 110 is realized as a standard metal contact to highly p-doped GaAs, as is common in the art of GaAs semiconductor lasers. In the case of a highly p-doped InGaP contact layer, an exemplary metallization for ohmic contacts can be:
1. Ti/Pt/Au: Ti (<50 nm), Pt (<100 nm), Au (>100 nm). Annealing: <400°C, Annealing time: <120 seconds

The contacts 109a and 109b need special considerations due to limitations related to the use of doped InGaP layers, and typical thermal limitations of heterogeneous systems that limit the activation/rapid thermal anneal temperatures to <450°C or lower. The choice of the metal stack and annealing conditions are the two most important factors. Some examples of InGaP ohmic contacts with <400°C activation temperatures suitable for present invention are the following:
2. Pd/Ge/Au: Pd (<20 nm), Ge (<200 nm), Au (>100 nm). Annealing: <375°C, Annealing time: <120 seconds
3. Ge/Ni/Ge/Au: Ge (<20 nm), Ni (<50 nm), Ge (<100 nm), Au (>100 nm). Annealing: <375°C, Annealing time: <120 seconds
The numbers in brackets suggest optimal thicknesses limits of particular metal layers, but it is clear to someone skilled in the art that various modifications can also result with ohmic contacts. All contacts can be connected to pad metal (not shown) through vias to facilitate efficient current and/or voltage control of the active device.

The upper cladding layer 107 can be any suitable material including, but not limited to, a polymer, SiO₂, SiN, SiNOₓ etc. In some embodiments, the same material is used for layer 107 and layer 108. In some embodiments (not shown), layer 107 cladding functionality can be provided with multiple depositions and multiple materials, e.g. to both provide cladding and passivation of the active device.

Dashed arrows 160 illustrate typical current injection paths from the top to lateral faces of the device, passing through the active region, and illustrate one of the key differences between heterogeneous integration and native (monolithic) photonic platforms. As illustrated in Fig. 1 the mode has significant overlap with at least one of the contact layers (n-contact in embodiment shown in FIG. 1). FIG. 2 provides additional details in this regard.

FIG. 2 shows some exemplary simulation results related to designing an optimal heterogeneous laser structure using an InGaP contact layer. View 200 shows the change of the confinement factor in the quantum well layer (part of sublayer 101-3), the InGaP bottom n-contact (part of sublayer 101-1), and the GaAs top p-contact (part of sublayer 101-5) as the thickness of InGaP layer 101-1 is changed between 50 nm and 500 nm. Note that the confinement in the plot is specified as a percentage. The confinement in the InGaP n-contact, in this exemplary laser structure, is ∼1% for contact thickness of 150 nm where such thickness can provide good series resistance. This demonstrates the importance of using low-loss, high-bandgap contact material. The impact of the p-contact is very small, as overall confinement is <1e-5 and approaching 1e-6 resulting in a small contribution to internal loss from the GaAs contact layer. Views 220, 240 and 260 show illustrative mode shapes (as contours) for an exemplary laser structure with InGaP bottom contact thicknesses of 50 nm, 150 nm and 250 nm respectively. The impact of the n-contact thickness is significant to the mode shape and control of both internal losses and confinement in quantum wells. Fine optimization of the optical mode can readily be performed using commercial solvers with standard material libraries to optimize the performance of active devices.

FIG. 3 shows six views (300, 310, 320, 330, 340 and 350) corresponding to device cross sections after some illustrative steps in the operations carried out to make integrated devices of the types described above. The operations for making the devices need not always include all the functions, operations, or actions shown, or to include them in exactly the sequence illustrated by the sequence from views 300 to 350.

In an exemplary case, however, operations specific to heterogeneous platform with InGaP layers result first in view 300, in which suitable passive structures 302 realized on substrate (105), bottom cladding (104), passive waveguide (102) and planarization layer (108), as shown and described in more detail with the help of FIG. 1, have dies or wafers of active layers 301 bonded thereupon, as is common in a heterogeneous process. The steps to achieve this are similar to steps described in e.g. U.S. Patent 10,641,959 or other heterogeneous integration references. Bonded active layers 301 comprise five sub-layers 101-1 to 101-5 as described with the help of FIG. 1, and also substrate 309 on which these five sub-layers are grown. There could be additional grown layers between the five sub-layers and substrate to facilitate better material quality (e.g. buffer layers) and/or substrate removal (e.g., etch stop layers).

The operations can then proceed to next step shown in view 310 in which substrate 309 has been removed so active layer 311 comprises only the five sub-layers as described above. The removal process can utilize a combination of mechanical grinding/lapping/polishing, chemical-mechanical polishing, dry etching and/or wet etching. In some embodiments, a layer of InGaP is used as selective layer to facilitate improved process control. In some embodiments, the substrate is mechanically thinned down to under 50 µm, and then the final substrate removal is performed with a selective etch resulting in very high uniformity of the substrate removal process. With removal of the substrate, only a thin layer comprising five sub-layers remains on the top surface of the passive structures (302) wafer. In some embodiments, the thickness of remaining layers is <5 µm allowing the use of high-quality photolithography for subsequent processing. The alignment between passive structures defined in 302 prior to bonding, and active structures that will be defined in following steps is extremely good (<250 nm or better) due to the use of common lithographical alignment marks on passive structures (302) wafer. This is one of the key advantages of heterogeneous integration in terms of device uniformity.

In this exemplary case, the process might proceed to view 320, showing a cross section after etching of mesa 323 (of width W_{M} 327) has been performed. Such etching can utilize dry and/or wet etching, and can also utilize an etch stop layer to improve uniformity across the wafer. The remaining active layers 321 are not etched in this step. In some embodiments InGaP is used as a selective etch stop layer when etching the mesa. In some embodiments, the mesa width is between 1 µm and 5 µm. In yet other, typically high-power designs, the mesa width is larger than 5 µm and can be as wide as 100 µm or more.

Next, the process might proceed to view 330, showing a cross section after etching of active portion 334 (of width W_{A} 337) is performed. Such etching can utilize dry and/or wet etching, and can also utilize an etch stop layer to improve uniformity across the wafer. The remaining active layer 331 (comprising sublayer 101-1 as described with the help of FIG. 1) is not etched in this step; it comprises an InGaP layer to provide the etch stop, and also contacts as described in relation to FIG. 1 and FIG. 2. In some embodiments, the active width 337 is larger than the mesa width 327 by at least 2 µm. In other embodiments (not shown), it can be substantially the same width as mesa width 327.

Next the process might proceed to view 340, showing a cross section after metal contacts 345 have been deposited. In some embodiments, deposition of the p-contact (top contact in view 340) can be done prior (e.g., after substrate removal in view 310, or after mesa etch in view 320), while the n-contact (bottom contact in view 340) has to be deposited after the active etch, once n-doped InGaP layer 341, corresponding to 101-1 in FIG. 1, is exposed. Metallization for p-, and n-doped layers is different as explained previously in relation to FIG. 1.

Finally, the process might proceed to cladding 359 deposition (as described in relation to FIG. 1 and layer 107), before opening vias and depositing pad metal 356. The result is shown in view 350.

Further processing of the various dielectric and/or semiconductor layers, and/or electrical contacts, vias and the addition and processing of index matching layers may be performed as is known in the art. This can include heaters, passivation, etching trenches, forming light blocking structures and/or similar.

The process leverages the advantages of InGaP layer to provide etch selectivity and high-bandgap contacts with low optical loss. With appropriate dry etch conditions (gas selection, plasma power etc.) or wet etchant (chemical selection), InGaP can be selectively removed from different group III/V compounds (such as GaAs), or vice versa, which provides premium process control and uniformity.

FIG. 4 is a schematic cross-section view of an integrated photonic device 400 utilizing butt-coupling and mode conversion for efficient coupling between dissimilar materials. Functional layers 401 to 408 (unless explicitly defined differently) correspond to functional layers 101 to 108 as described in relation to FIG. 1.

Layer 408, whose refractive index is lower than the refractive index of layer 402, overlays layer 402 and underlays layers 401 and 403 (described in more detail below).

Layer 401 is bonded onto a top surface of at least part of the corresponding passive waveguide structure, including layer 402, and optionally 408. Layer 401 makes up what is commonly called an active device and comprises sub-layer 401a (comprising sublayers 101-2, 101-3, 101-4 and 101-5 as described with the help of FIG. 1), and sub-layer 401b comprising sublayer 101-1 as described with the help of FIG. 1. 401b comprises a highly doped InGaP layer used to provide the contacts, while being optically transparent at the wavelength of operation. The overlap between optical mode 450 (which is guided inside the active device) and sub-layer 401b is significant (as also illustrated with FIG. 2), and, in some embodiments, the evanescent tail of the optical mode extends to layers 402/408. Periodic structures in 402/408 can therefore provide optical feedback to realize distributed feedback (DFB) lasers or similar.

Efficient coupling between optical mode 450 supported in active structure 401 and optical mode 453 supported in passive structure for which layer 402 provides the core is facilitated by layer 403, and, in cases where layer 406 is present, by layer 406. Optional layer 406 primarily serves as either an anti-reflective or a highly reflective coating at the interface between layer 401 and layer 403. Layer 403 serves as an intermediate waveguide that in some embodiments accepts the profile (depicted by line 450) of an optical mode supported by the waveguide for which layer 401 provides the core, captures it efficiently as mode profile 451, and gradually transfers it to mode profiles 452, and finally 453. Mode profile 453 is efficiency coupled to the waveguide for which layer 402 provides the core.

The use of intermediate layer 103 significantly improves efficient transfer between very high refractive index materials supporting operating at short wavelength range (such as e.g. GaAs/InP and their ternaries and quaternaries) to low refractive index materials, such as e.g. SiN, SiNOx, TiO₂, Ta₂O₅, (doped) SiO₂, LiNbO₃ and AlN, in layer 402.

Differences between the optical modes supported by waveguides in layers 401 and 402 respectively may or may not be obvious by observation of the mode profiles, but mode shape overlaps less than 100% along with non-zero vertical offsets (in FIG. 4) between modes 450 and 453 could (in the absence of intermediate layer 403) result in significant optical loss. In some cases, losses of up to 2 dB may be considered acceptable, but losses greater than that might not be. In other cases, a 5 dB loss level may be the criterion chosen for acceptability. The function of layer 403 is to keep optical coupling losses due to imperfect mode overlap and vertical offset (between modes 450 and 453) below whatever is determined to be an acceptable level in a given application.

In some embodiments, layer 408 is not present and both layers 401 and 403 are positioned on top of a patterned layer 402, 401 by bonding, and 403 by various deposition methods. In such embodiments, there is no planarization step.

It is to be understood that these illustrative embodiments teach just some examples of heterogeneously integrated lasers and active components operating at short wavelengths utilizing the present invention, and many other, similar arrangements can be envisioned. Furthermore, such lasers and active components can be combined with multiple other components to provide additional functionality or better performance such as various filtering elements, amplifiers, monitor photodiodes, modulators and/or other photonic components.

Embodiments of the present invention offer many benefits. The integration platform enables scalable manufacturing of PICs made from multiple materials providing higher-performance and/or ability to operate in broadband wavelength range. Furthermore, the platform is capable of handling high optical power compared to typical Si waveguide-based or InP waveguide-based PICs.

This present invention utilizes a process flow consisting typically of wafer-bonding of a piece of compound semiconductor material on a carrier wafer with dielectric waveguides (as is described with the help of FIGs. 1, 3 and 4) and subsequent semiconductor fabrication processes as is known in the art. It enables an accurate definition of optical alignment between active and passive waveguides typically via a lithography step, removing the need for precise physical alignment. Said lithography-based alignment allows for scalable manufacturing using wafer scale techniques.

It is to be understood that optical coupling between modes in active and passive layers is reciprocal, so that, taking FIG. 4 as exemplary, the structure can be configured to facilitate light transmission from region 401 to region 402, but it could also facilitate transmission in the reverse direction, from region 402 to region 401. It is to be understood that multiple such transitions with no limitation in their number or orientation can be realized on a suitably configured PIC.

Other approaches have relied on die attachment of prefabricated optical active devices to passive waveguides. This requires very stringent alignment accuracy which is typically beyond what a typical die-bonder can provide. This aspect limits the throughput of this process as well as the performance of optical coupling.

In some embodiments, the active device creates a hybrid waveguide structure with dielectric layers which can be used, for example, to create a wavelength selective component formed inside the laser cavity for e.g. distributed feedback (DFB) lasers or similar components.

Embodiments of the optical devices described herein may be incorporated into various other devices and systems including, but not limited to, various computing and/or consumer electronic devices/appliances, communication systems, computational systems, medical devices, sensors and sensing systems.

It is to be understood that the disclosure teaches just few examples of the illustrative embodiment and that many variations of the invention can easily be devised by those skilled in the art after reading this disclosure and that the scope of the present invention is to be determined by the following claims.

### Embodiments

1. A heterogenous device comprising:
   a passive waveguide structure attached to a substrate; the passive waveguide structure comprising a dielectric layer; and
   an active waveguide structure attached to a top surface of the passive waveguide structure; the active waveguide structure comprising a quantum well layer overlying an InGaP layer;
   wherein the InGaP layer provides n-contact functionality.
2. The heterogenous device of embodiment 1,
   wherein the InGaP layer is characterized by a thickness between 50nm and 500nm.
3. The heterogenous device of embodiment 1,
   wherein the InGaP layer is characterized by a doping concentration >=1e18.
4. The heterogenous device of embodiment 1,
   wherein the InGaP layer acts as a bonding layer between a bottom surface of the active structure and the top surface of the passive waveguide structure.
5. The heterogenous device of embodiment 1,
   wherein the InGaP is a layer within a superlattice; and
   wherein the superlattice comprises a bonding interface of the active structure.
6. The heterogenous device of embodiment 1,
   wherein the passive waveguide structure comprises a dielectric layer comprising at least one of SiN, SiNOx, TiO2, Ta2O5, (doped) SiO2, LiNbO3 and AlN.
7. The heterogenous device of embodiment 6,
   wherein the dielectric layer is characterized by a thickness between 50 nm and 600 nm.
8. The heterogenous device of embodiment 1,
   wherein metallization for a contact made to the InGaP layer comprises at least one of Pd, Ge, Au, and Ni.
9. The heterogenous device of embodiment 1, wherein the active structure comprises a p-cladding layer overlying the quantum well layer, the p-cladding layer being characterized by a thickness > 400 nm
10. The heterogenous device of embodiment 1,
   wherein a top surface of the passive waveguide structure to which the active structure is bonded is characterized by a roughness < 1 nm rms.
11. The heterogenous device of embodiment 1,
   wherein the active waveguide structure has a cross sectional shape characterized by a mesa of width W_{M} where 1 µm >= W_{M} <=5 µm.
12. The heterogenous device of embodiment 11,
   wherein the shape is further characterized by an active width W_{A} where W_{A} = W_{M} +2 um.
13. The heterogenous device of embodiment 1,
   wherein the active waveguide structure has a cross sectional shape characterized by a mesa of width W_{M} where 5 µm >= W_{M}.
14. The heterogenous device of embodiment 1,
   wherein the active waveguide structure comprises a second InGaP overlying the quantum well layer, acting as an etch stop layer.
15. A heterogenous device comprising:
   a passive waveguide structure attached to a substrate; the passive waveguide structure comprising a semiconductor layer; and
   an active waveguide structure attached to a top surface of the semiconductor waveguide structure; the active waveguide structure comprising a quantum well layer overlying an InGaP layer;
   wherein the InGaP layer provides n-contact functionality.
16. The heterogenous device of embodiment 15,
   wherein the semiconductor waveguide structure comprises a semiconductor layer with bandgap >= 1.5 eV.
17. The heterogenous device of embodiment 15,
   wherein the InGaP layer is characterized by a thickness between 50nm and 500nm.
18. The heterogenous device of embodiment 15,
   wherein the InGaP layer is characterized by a doping concentration >=1e18.
19. The heterogenous device of embodiment 15,
   wherein the InGaP layer acts as a bonding layer between a bottom surface of the active structure and the top surface of the dielectric waveguide structure.
20. The heterogenous device of embodiment 15,
   wherein the InGaP is a layer within a superlattice; and
   wherein the superlattice comprises a bonding interface of the active structure.

## Claims

1. A heterogenous device comprising:
a passive waveguide structure attached to a substrate; the passive waveguide structure comprising a dielectric layer; and
an active waveguide structure attached to a top surface of the passive waveguide structure; the active waveguide structure comprising a quantum well layer overlying an InGaP layer;
wherein the InGaP layer provides n-contact functionality.

2. The heterogenous device of claim 1,
wherein the InGaP layer is **characterized by** a thickness between 50nm and 500nm.

3. The heterogenous device according to any of the preceding claims,
wherein the InGaP layer is **characterized by** a doping concentration >=1e18.

4. The heterogenous device according to any of the preceding claims,
wherein the InGaP layer acts as a bonding layer between a bottom surface of the active structure and the top surface of the passive waveguide structure.

5. The heterogenous device according to any of the preceding claims,
wherein the InGaP is a layer within a superlattice; and
wherein the superlattice comprises a bonding interface of the active structure.

6. The heterogenous device according to any of the preceding claims,
wherein the passive waveguide structure comprises a dielectric layer comprising at least one of SiN, SiNOx, TiO2, Ta2O5, doped or undoped SiO2, LiNbO3 and AlN.

7. The heterogenous device of claim 6,
wherein the dielectric layer is **characterized by** a thickness between 50 nm and 600 nm.

8. The heterogenous device according to any of the preceding claims,
wherein metallization for a contact made to the InGaP layer comprises at least one of Pd, Ge, Au, and Ni.

9. The heterogenous device according to any of the preceding claims, wherein the active structure comprises a p-cladding layer overlying the quantum well layer, the p-cladding layer being **characterized by** a thickness > 400 nm

10. The heterogenous device according to any of the preceding claims,
wherein a top surface of the passive waveguide structure to which the active structure is bonded is **characterized by** a roughness < 1 nm rms.

11. The heterogenous device according to any of the preceding claims,
wherein the active waveguide structure has a cross sectional shape **characterized by** a mesa of width W_{M} where 1 µm >= W_{M} <=5 µm,
wherein the shape is in particular further **characterized by** an active width W_{A} where W_{A} = W_{M} +2 um.

12. The heterogenous device according to any of the preceding claims,
wherein the active waveguide structure has a cross sectional shape **characterized by** a mesa of width W_{M} where 5 µm >= W_{M}.

13. The heterogenous device according to any of the preceding claims,
wherein the active waveguide structure comprises a second InGaP overlying the quantum well layer, acting as an etch stop layer.

14. A heterogenous device comprising:
a passive waveguide structure attached to a substrate; the passive waveguide structure comprising a semiconductor layer; and
an active waveguide structure attached to a top surface of the semiconductor waveguide structure; the active waveguide structure comprising a quantum well layer overlying an InGaP layer;
wherein the InGaP layer provides n-contact functionality.

15. The heterogenous device of claim 14,
wherein the semiconductor waveguide structure comprises a semiconductor layer with bandgap >= 1.5 eV; and/or
wherein the InGaP layer is **characterized by** a thickness between 50nm and 500nm;
and/or
wherein the InGaP layer is **characterized by** a doping concentration >=1e18; and/or
wherein the InGaP layer acts as a bonding layer between a bottom surface of the active structure and the top surface of the dielectric waveguide structure; and/or
wherein the InGaP is a layer within a superlattice; and wherein the superlattice comprises a bonding interface of the active structure.
